(19)

**Europäisches Patentamt**
**European Patent Office**
**Office européen des brevets**

(11)  **EP 4 601 133 A1**

(12) **EUROPEAN PATENT APPLICATION**

(43) Date of publication:
**13.08.2025 Bulletin 2025/33**

(21) Application number: **25155704.7**

(22) Date of filing: **04.02.2025**

(51) International Patent Classification (IPC):
*H01S 3/094* (2006.01)    *H01S 5/042* (2006.01)
*H01S 5/183* (2006.01)    *H01S 5/42* (2006.01)
*H01S 3/0941* (2006.01)    *H01S 5/065* (2006.01)
*H01S 5/40* (2006.01)    *H01S 5/00* (2006.01)

(52) Cooperative Patent Classification (CPC):
**H01S 3/094003; H01S 3/094053; H01S 5/04253;**
**H01S 5/04256; H01S 5/18361; H01S 5/18375;**
**H01S 5/423;** H01S 3/09408; H01S 3/09415;
H01S 5/005; H01S 5/02253; H01S 5/02345;
H01S 5/0656; H01S 5/18305; H01S 5/18358;
(Cont.)

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **07.02.2024 IL 31071024**

(71) Applicant: **Semiconductor Devices Ltd.**
**D.N. Misgav, 2017900 (IL)**

(72) Inventors:
• KARNI, Yoram
**Quiryat Tivon 3604423 (IL)**
• YANSON, Dan
**Haifa 3288212 (IL)**

(74) Representative: **Vossius & Partner**
**Patentanwälte Rechtsanwälte mbB**
**Siebertstrasse 3**
**81675 München (DE)**

(54) **SURFACE EMITTING SEMICONDUCTOR LASER SYSTEM**

(57) A fiber laser pump module comprising one or more lasing clusters comprising a plurality of lasing units disposed in a common plane. The lasing units are optically decoupled, such that light emitted by one lasing unit does not interfere with light of another lasing unit. The lasing units comprise at least some coherent lasing units, each coherent lasing unit includes a plurality of semiconductor surface-emitting laser elements that are mutually optically coupled, so that light emitted by one surface-emitting element interfere with light emitted by another surface-emitting element. Further included are one or more phase correctors for manipulating light emitted by the coherent lasing units to output corrected beams propagating in a single direction and having a far field pattern predominated by a single main lobe. A focusing optics assembly for focusing said corrected beams into a focused beam. An optical fiber for receiving and outputting the focused beam.

Fig. 1A

(52) Cooperative Patent Classification (CPC): (Cont.)
H01S 5/4012; H01S 5/4018

## Description

## TECHNOLOGICAL FIELD

The present disclosure is generally in the field of high-power laser light sources. In particular, the present disclosure relates to laser-diode pump modules for fiber lasers.

## BACKGROUND

High-power fiber lasers require optical pumping using fiber-coupled pump modules based on laser diodes, also known as semiconductor lasers. Various pump modules for fiber lasers have been disclosed in the prior art and are generally based on edge-emitting semiconductor laser emitters.

For example, edge-emitter-based modules are described in US Patent No. US 7,773,655, US 8,000,360; US 7,733,932; US 7,764,723; US 6,898,222; US 8,437,086; US 8,427,749; US 8,711,894; US 6,124,973; and US 7,751,458.

Alternative pump module implementations are disclosed in US Pat. 8,576,885 and US Pat. 8,929,407 and make use of a class of surface-emitting semiconductor lasers known as vertical-cavity surface-emitting lasers (VCSEL).

## GENERAL DESCRIPTION

Pump modules based on edge-emitting semiconductor lasers suffer from the complexity of a non-planar arrangement of semiconductor laser chips, e.g., as shown in US 7,773,655. The non-planar arrangement compromises the removal of waste heat and adds both volume and weight. Furthermore, the optical architecture of such modules involves a large plurality of micro-optical elements (mostly lenses and mirrors), each requiring active optical alignment.

In contrast, pump modules based on semiconductor lasers in a surface-emitting geometry, or surface-emitting lasers (SEL for short), are substantially immune to the above issues but face other technical challenges. A common type of SEL is vertical-cavity surface-emitting lasers (VCSEL for short), where laser oscillation occurs between epitaxially grown mirrors and the vertical cavity, is only several micrometers long. As a result, individual VCSEL sources emit low milliwatt-level powers, thus a great number (thousands) of VCSEL elements are needed to reach the required multi-Watt level pump powers, necessitating a large emitting area. A fundamental issue arises with the large emitting area occupied by the thousands of individual VCSEL elements, and their high divergence. The angular divergence of VCSEL emission is typically larger than 5 degrees, which requires collimation of each element with a lens (typically, a micro-lens), so that the resulting array of collimated beams emitted by the VCSEL array can be focused to a single spot and coupled into an optical fiber. However, the addition of collimation lenses, even in the form of a compact micro-lens array, greatly increases the element spacing within the array and thus the area occupied by the array. The larger the diameter of each collimation lens, the better the collimation (the lower the divergence), but also larger is the total area. The combined array beam diameter becomes prohibitively large and exceeds the etendue (also expressed as the beam parameter product) of a receiving optical fiber. In other words, the product of an acceptance angle of the fiber and its receiving cross-section (core diameter), limits the product of an emission angle of the combined VCSEL source and its combined beam diameter. Thus, the combined VCSEL emitting area is limited, and so is the maximum achievable power. Expressed in terms of brightness (also known as radiance), the brightness of the source may be equal or exceed that of the fiber into which it is coupled. This limitation is of fundamental physical nature and cannot be overcome by improved engineering of VCSEL layout, collimating or focusing optics.

In other words, conventional VCSEL and their arrays lack sufficient brightness to achieve a combination of high output wattage and low beam parameter product, as required for fiber-laser pumping. Therefore, despite its architectural simplicity and low-cost manufacturability, the current high-power surface-emitting laser diode technology is not competitive with edge-emitting pump modules.

Coherent surface-emitting laser (coherent SEL) assemblies can potentially offer significantly higher brightness than incoherent SEL assemblies, such as incoherent VCSEL arrays employed in US Pat. 8,576,885 and US Pat. 8,929,407. Here, the term "coherent" refers to a fixed optical phase relationship (or phase locking) across the whole or part of the emission area. To achieve coherence, individual emitting elements in a SEL may be optically coupled so that collective lasing of the SEL ensemble occurs predominantly in a single collective mode with a narrow spectral linewidth. The collective mode may be referred to as a "supermode" that spans and interlocks all, or most, individual emitting elements in the SEL. By optical interference throughout propagation of the emitted coherent field, the angular divergence of the source can be reduced as more and more elements are added to the coherent SEL. An increase in the coherent source area is thus offset by a decrease in its collective divergence. Therefore, coherent power scaling is possible without increasing the etendue, or the beam parameter product, of the source. Extending the aperture of a coherent source scales its brightness as a fourth power of the emitting aperture size $D$: first, the total power is proportional to the aperture area, or $\sim D^2$. Second, the beam divergence from the aperture is proportional to $D^{-1}$, with a solid angle proportional to $D^{-2}$, which adds up to an overall brightness scaling as $D^4$. With a sufficiently large coherent aperture D, the fiber laser pumping brightness requirements can be met and even exceeded.

Ways of achieving coherence in SEL (also referred to as coherence between SEL emitting elements hereinbelow) vary in the art, and typically involve placing the emitting elements very close together with a view, for imposing strong optical coupling. Such strongly coupled elements may still be distinguishable as emitters (e.g., elements of a surface-emitting array) or lumped together into a typically periodic structure, such as a photonic crystal or diffraction grating. In the latter case, a single unit cell of a photonic crystal, or period of a grating, or an element of a photonic lattice, can be defined as a surface-emitting element.

Coherent SEL may employ photonic crystals (e.g., as disclosed in WO 2023110203, US Pat. 7,009,216, WO 2021220276, US Pat. 7,535,943). Examples of photonic crystal SEL (PCSEL) include waveguide-integrated PCSEL, topological SEL, and active photonic lattice PCSEL.

Coherent SEL may also include a vertical cavity to operate as coupled VCSEL arrays (e.g., as disclosed in US Pat. 6,507,595, US Pat. 5,086,430, US Pat. 6,608,849, US Pat. 5,903,590, JP Pat. 2022043541), where predominant laser oscillation occurs between the epitaxially grown mirrors, but lateral (in-plane) phase locking is provided by various techniques, such as reflectivity modulation, anti-guide coupling, and slow-light modes.

Most coherent SEL rely on strong optical coupling among the emitting elements, unit cells or grating periods, to achieve surface emission that is characterized by a fixed optical phase relationship among them. In most cases, the emitting elements are arrayed across two dimensions on the SEL surface (e.g., as a 2D array), but one-dimensional SEL (e.g., as a 1D or linear array) have also been reported. The device design would typically enhance the output of most of the optical power through either the top or bottom surface of the SEL. However, coherent SEL known in the art suffer from three limitations. The first is that coherence length, expressed as the lateral extent of the SEL over which coherence is maintained, is limited by both the lasing linewidth and the uniformity of the manufacturing process. Other effects, such as electrical pumping variation and thermal lensing, may reduce the coherent extent even further. The power emitted by such coherence length-limited aperture is insufficient for fiber laser pumping. The second limitation is a multi-lobed far-field emission pattern, which is unsuitable for fiber coupling. While each individual lobe or beamlet in the far-field may be very narrow and have a near diffraction-limited angular divergence, the angular envelope of the overall emission pattern is too broad to meet the beam-parameter product of the receiving fiber. The third limitation lies in the fact that, even where most of the emission is concentrated in the central (on-axis) lobe, a significant amount of energy may still reside in the parasitic side lobes (sometimes referred to as grating lobes) due to incomplete filling of the SEL emission aperture.

The present disclosure aims to provide a high-brightness surface-emitting laser-diode module that is advantageous for use as a fiber laser pump device with significant benefits in terms of lower system complexity, volume, weight, assembly time, and cost. At the same time, the utility of the disclosure is not limited to fiber laser pumping, and can include many other applications where the disclosed high-brightness laser module can prove highly beneficial, such as laser cutting, engraving, materials processing, LiDAR (Light Detection and Ranging), pumping of EDFA (Erbium-doped optical fiber amplifiers) and of other Er-doped gain media, second-harmonic generation, and more.

In accordance with the presently disclosed subject matter, there is provided a laser module (for example a fiber laser pump module). The laser module includes one or more lasing clusters. The (one or more) lasing clusters include a plurality of lasing units. The plurality of lasing units being disposed on a common plane. The plurality of lasing units are optically decoupled. The optical decoupling is such that light waves emitted by one lasing unit does not interfere with light waves of another lasing unit. The plurality of lasing units includes at least some coherent lasing units. Each coherent lasing unit includes a plurality of semiconductor surface-emitting laser elements. The plurality of semiconductor surface-emitting laser elements are mutually optically coupled. The optical coupling is so that light waves emitted by one surface-emitting element interfere with light waves emitted by another surface-emitting element. The laser module includes one or more phase correctors configured to receive emitted light from the one or more lasing clusters. The (one or more) phase correctors include at least some optical phase correction elements. The optical phase correction elements are configured for manipulating light emitted by the at least some coherent lasing units, so as to produce interference to output corrected beams. The corrected beams are propagating substantially in a single direction and having a far field pattern predominantly formed by a single main lobe. The laser module includes a focusing optics assembly. The focusing optics assembly is configured downstream of the one or more phase correctors. The focusing optics assembly is for focusing the corrected beams into a focused beam. The laser module includes an optical fiber for receiving and outputting the focused beam. An input end of the optical fiber is disposed in a focal plane of the focusing optics assembly.

In addition to the above features, a laser module according to the presently disclosed subject matter, can optionally comprise one or more of features (i) to (xxxii) below, in any technically possible combination or permutation:

> i. the plurality of lasing units are disposed by a first proximity. The first proximity being at least a predefined threshold, so as to prevent mutual optical proximity coupling. The plurality of surface-emitting elements in each coherent lasing unit are disposed by a second proximity. The second proximity being shorter than the predefined threshold, so as to induce mutual optical proximity coupling.

ii. the predefined threshold is less than 10 times the wavelength emitted by the surface-emitting elements, wherein the wavelength defined according to light propagation in free space.

iii. the predefined threshold is 10 micrometers.

iv. the single main lobe carries at least 50% of an optical power carried by the far field pattern, preferably at least 75%, more preferably at least 90%, even more preferably at least 99%.

v. a divergence of the corrected beams is up to 3 times a diffraction limit of a lasing unit.

vi. each lasing unit is configured to emit a power of at least 100mW with a spectral linewidth less than 1 nm, preferably less than 0.5 nm.

vii. including a plurality of lasing clusters, each lasing cluster being formed from a separate semiconductor die and containing one or more lasing units.

viii. the lasing clusters are electrically connected in series, wherein a cathode of a lasing cluster is electrically connected to an anode of a following lasing cluster.

ix. all lasing units in at least one lasing cluster are electrically connected in parallel.

x. the surface-emitting elements include any of: a photonic crystal, a photonic lattice, an optical grating, a distributed Bragg reflector (DBR), a distributed feedback (DFB) region, an etched region, a metal region, a dielectric region, a regrown semiconductor region, a reflectivity-modulated region.

xi. the surface-emitting elements included in at least one of the at least some coherent lasing units are arrayed on a period of less than 10 micrometers.

xii. the one or more phase correctors are configured to provide amplitude-to-phase conversion for increasing an optical power propagating in the single direction.

xiii. the one or more phase correctors include any of phase plate, phase mask, phase-shift mask, phase-delay plate, wavefront corrector, metasurface, Fourier hologram, transmission grating, phase grating, Dammann grating, and diffractive optical element.

xiv. the one or more phase correctors include any of phase levels, pillars, blocks, slits, nanopillars, nanoblocks, and nanoslits.

xv. having an output brightness of at least 2 MW/(sq.cm×srad).

xvi. an emission wavelength of the plurality of surface-emitting elements is in the range of 770 nm to 1070 nm, preferably any of 915 nm and 976 nm.

xvii. includes one or more first lasing cluster, configured to emit light waves in a first polarization. Includes one or more second lasing cluster configured to emit light waves in a second polarization. Includes a polarization-sensitive reflector configured for combining emitted light by the one or more first lasing cluster and the one or more second lasing cluster.

xviii. including a dichroic module configured for blocking a backwards propagation of wavelengths distinct from a wavelength emitted by the one or more lasing cluster. The dichroic module is positioned between the one or more phase correctors and the focusing optics assembly.

xix. the dichroic module is inclined with respect to the single direction of the corrected beams.

xx. including a micro-lens array disposed between at the lasing units and the one or more phase correctors. The micro-lens array is configured for Fourier imaging of light waves emitted by at least some of the lasing units. At least some micro-lenses correspond to at least some of the lasing units.

xxi. one phase corrector is integrated into the lasing cluster.

xxii. the focusing optics assembly includes two cylindrical lenses oriented along different axes.

xxiii. the focusing optics assembly includes a single lens.

xxiv. light emitted from the coherent lasing units forms a plurality of far-field lobes, preferably four lobes.

xxv. the lasing units include any of the semiconductor materials GaAs, AlAs, AlGaAs, InGaAs, InGaAsP, InP, and GaN.

xxvi. the lasing units include tunnel junctions or buried tunnel junctions.

xxvii. the emitted light is emitted from a substrate side of the lasing units.

xxviii. configured to receive power from a power supply unit configured to supply power for edge-emitting laser modules.

xxix. a current supplied by a power supply unit is in the range of 10A to 30A.

xxx. a first section of the optical fiber is surrounded by a first encapsulation medium, and a second section of the fiber is surrounded by a second encapsulation medium inside a ferrule, wherein the first and second encapsulation media having a refractive index close to, but higher than that of the fiber.

xxxi. the refractive index is in the range of 1.45 to 1.6.

Applications that can benefit the incorporation of the laser module as disclosed herein, include fiber laser pump modules, and fiber laser systems.

In the present disclosure, the following terms and their derivatives may be understood according to the below explanations:

The term "optical power" may refer to power (energy per time) carried by optical radiation.

The term "intensity" may refer to power density (power per area) carried by optical radiation.

The term "light waves" may be used to refer to an optical radiation.

The term "brightness" may refer to the physical quantity of power per-area per-solid-angle. Units of brightness may be, for example, watts per-square-centimeters per-steradian ( $\frac{W}{cm^2 \times sr}$ ). The term "radiance" may be a synonym for the term "brightness".

The term "coherence" may refer to a degree of phase correlation between individual emitting elements within a laser array or ensemble. Coherence may determine the extent to which the emitted light waves from different lasing elements are in phase with each other and can interfere with each other, in order to produce far-field radiation patterns that are substantially different from those of individual elements taken in isolation.

The term "optical coupling" may refer to an arrangement enabling two or more emitting elements to function in a synchronized manner so that the two elements emit light with a time-invariant phase relationship.

The term "mutual optical proximity coupling" may refer to a physical closeness or spatial proximity of two or more sources of waves, such as light or electromagnetic radiation. When two or more emitting elements are positioned within a distance that is comparable to the wavelength of the waves they emit, the electromagnetic fields they generate can interact. This interaction can lead to correlations in the phases of the emitted waves, affecting the overall coherence of the sources. Here, the most common interpretation of the term "wavelength" refers to the wavelength of the emitted radiation. However, in the case of photonic-crystal SEL, optical interaction in the plane of the photonic crystal lattice may occur at a very low group velocity associated with the so called "slow light", e.g., as disclosed in EP3425755 and JP2022/043541. Owing to a very low modal effective refractive index associated with in-plane propagation, such "slow light" may have a characteristic wavelength, and a proximity coupling distance, that are significantly larger (e.g., 20 times longer) than the free-space wavelength of the emitted radiation is possible.

The term "optical decoupling" or "optically decoupled" implies absence of "mutual optical proximity coupling" as described above but may include coupling or combination (e.g., beam combining) into a common receptacle (e.g., an optical fiber or a phase corrector), where such coupling or combination produces no optical feedback and has no effect on the behavior or properties of the sources (e.g., lasing units or emitting elements), specifically, with regard to their coherence.

**BRIEF DESCRIPTION OF THE DRAWINGS**

In order to better understand the subject matter that is disclosed herein and to exemplify how it may be carried out in practice, embodiments will now be described, by way of non-limiting example only, with reference to the accompanying drawings, in which:

**Fig. 1A-1B** schematically illustrate a fiber laser pump module, according to embodiments of the present disclosure.

**Fig. 2A-2B** schematically illustrate another fiber laser pump module, according to embodiments of the present disclosure.

**Fig. 3A-3B** schematically illustrate a fiber laser pump module including an amplitude-to-phase converter, according to embodiments of the present disclosure.

**Fig. 4A-4B** schematically illustrate fiber laser pump modules including polarization beam combining, according to embodiments of the present disclosure.

**Fig. 5A-5B** schematically illustrate a lasing cluster comprising a plurality of coherent lasing units, according to embodiments of the present disclosure.

**Fig. 6A-6B** schematically illustrate a spatial arrangement of lasing clusters **(Fig. 6A),** and a corresponding mounting baseplate **(Fig. 6B),** according to embodiments of the present disclosure.

**Fig. 7** schematically illustrates a fiber optic cable coupling assembly, according to embodiments of the present disclosure.

**DETAILED DESCRIPTION OF EMBODIMENTS**

Described herein are some examples of laser modules that are particularly advantageous for fiber laser pumping, but many other applications may exist. In the following detailed description, numerous specific details are set forth in order to provide a thorough understanding of the subject matter. However, it will be understood by those skilled in the art that some examples of the subject matter may be practiced without these specific details. In other instances, well-known methods, procedures and components have not been described in detail so as not to obscure the description.

As used herein, the phrases "for example," "such as", "for instance" and variants thereof describe non-limiting examples of the subject matter.

Reference in the specification to "one example", "some examples", "another example", "other examples, "one instance", "some instances", "another instance", "other instances", "one case", "some cases", "another case", "other cases" or variants thereof means that a particular described feature, structure or characteristic is included in at least one example of the subject matter, but the appearance of the same term does not necessarily refer to the same example. The term "each" may not be exclusively understood as referring to each and every, and when technically relevant may also refer to "at least some".

It should be appreciated that certain features, structures and/or characteristics disclosed herein, which are, for clarity, described in the context of separate examples, may also be provided in combination in a single example. Conversely, various features, structures and/or characteristics disclosed herein, which are, for brevity, described in the context of a single example, may also be provided separately or in any suitable subcombination.

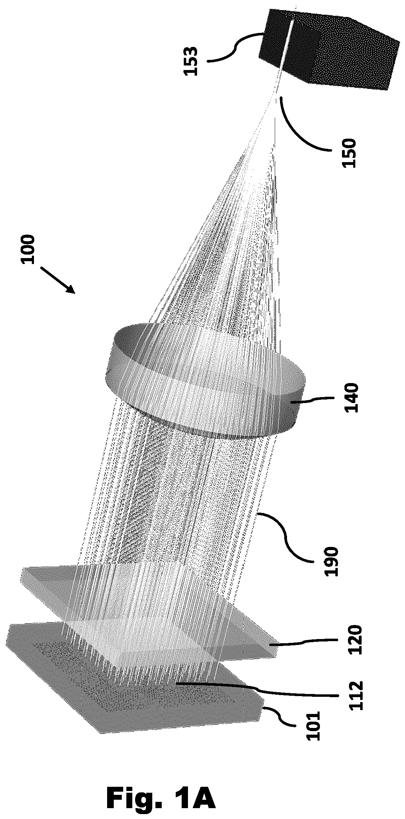

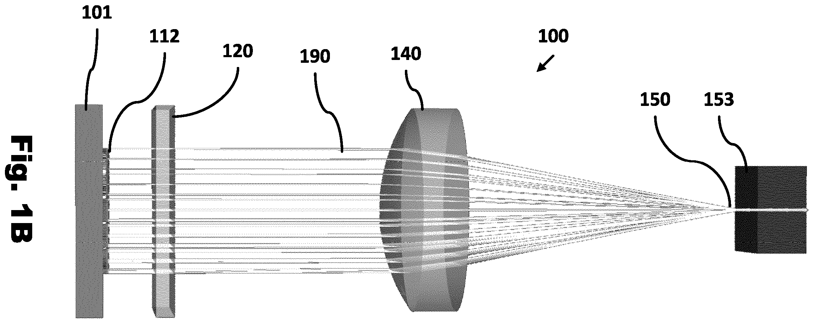

**Figs. 1A-1B** schematically illustrate a fiber laser pump module **100,** according to embodiments of the present disclosure. **Fig. 1A** illustrates the fiber laser pump module **100** in a perspective view, whereas **Fig. 1B** illustrates the fiber laser pump module **100** in a top (or plan) view.

The fiber laser pump module **100** may include one or more lasing clusters **112**. The one or more lasing clusters **112** may include one or more surface-emitting lasing unit disposed on a common surface, for example, a baseplate **101.The** lasing units may have their emitting surfaces aligned in a common emitting plane, e.g., at the same height from baseplate **101,** which may greatly simplify the optical architecture of the module.

The baseplate **101** may provide both the electrical connections and waste heat removal for the one or more lasing cluster **112**. For example, baseplate **101** may be mounted onto a thermo-electric cooler or other cooling means, such a water-cooled or microchannel-cooled carrier.

Depending on the properties, such as power and thermal requirements of the lasing units, the lasing units can be arranged in many different ways in order to reach high aggregate optical wattage (optical power). Such a plurality of lasing units may be obtained, for example, by many clusters of several lasing units each or of just one lasing unit each, or by a single large cluster of many lasing units.

In some embodiments, the plurality of lasing units may be optically decoupled, i.e., the lasing units are mutually incoherent. In other words, light waves emitted by one lasing unit may not interfere with light waves of another lasing unit. The optical decoupling may be achieved by a separation the lasing units being at least several times the emission wavelength, e.g., 10 wavelengths or more, to prevent optical interaction, or proximity coupling, between any two adjacent lasing units. In other words, the distance between one lasing unit and another may be greater than a predefined threshold (e.g., in some embodiments, more than 9 microns). In some embodiments, the optical decoupling may be enhanced by a structural perturbation between adjacent lasing units, such as etching, dicing, sawing, or depositing an optically opaque or reflecting material. As a result, the lasing units may emit light as independent sources, such that their incoherent combination results in a total intensity, in the far field, that is substantially equal to the sum of the intensities of the individual lasing units.

The plurality of lasing units may include at least some coherent lasing units. Preferably, all lasing units may be coherent lasing units. In some embodiments, a coherent lasing unit may be formed by a coherent semiconductor surface-emitting laser having surface-emitting elements. In other embodiments, a coherent lasing unit may be formed by a coherent semiconductor surface-emitting laser array, wherein the surface-emitting elements are formed by individual SEL. In some embodiments, the SEL may be a VCSEL. In some embodiments, a lasing unit may be formed by a VCSEL or a VCSEL array.

The plurality of the surface-emitting elements may be mutually optically coupled, so that light waves emitted by one surface-emitting element interfere with light waves emitted by another surface-emitting element. A coherent lasing unit may preferably be formed by a coherent semiconductor laser source including a plurality of surface-emitting elements that are optically proximity-coupled to one another. Here, proximity coupling may imply mutual coupling between the surface-emitting elements (e.g., nearest-neighbor coupling, evanescent coupling, or diffractive coupling) and may be enabled by their physical closeness or spatial proximity. When the surface-emitting elements are positioned within a distance that is comparable to the wavelength of the waves they emit, the electromagnetic fields they generate can interact. This interaction occurs when the distance from one surface-emitting element to another may be less than a predefined threshold (e.g., in some embodiments, less than 5 microns). This interaction can lead to a consistent correlation in the phases of the emitted waves, leading to the overall coherence of the coherent lasing unit.

The separation between surface-emitting elements, and the separation between lasing units, may be summarized as follows: the plurality of lasing units may be disposed by a first proximity being at least a predefined threshold so as to prevent mutual optical proximity coupling. The plurality of surface-emitting elements, in each coherent lasing unit, may be disposed by a second proximity being shorter than the predefined threshold, so as to induce mutual optical proximity coupling. In some embodiments, the predefined threshold may be less than 10 times the wavelength emitted by the surface-emitting elements. The wavelength may be defined according to light propagation in free space, i.e., not according to a wavelength of "slow light". In some embodiments, the predefined threshold may be 10 micrometers.

In some embodiments, the surface-emitting elements may include (be formed by) any of: a photonic crystal, a photonic lattice, an optical grating, a distributed Bragg reflector (DBR), a distributed feedback (DFB) region, an etched region, a metal region, a dielectric region, a regrown semiconductor region, and/or a reflectivity-modulated region. In some embodiments, the surface-emitting elements may be arrayed in a periodic fashion (i.e., may be periodically arrayed), with a period of less than 10 micrometers. In some embodiments, a surface-emitting element may be formed by any of: a unit cell of a photonic crystal, a period of a grating, and an element of a photonic lattice.

By virtue of the phase correlation that is limited to a single coherent lasing unit, the surface-emitting elements of one lasing unit may interfere with each other in free space, and they may not interfere with the surface-emitting elements of another lasing unit. In some embodiments, the emitted light from a lasing unit may form a plurality of far-field lobes. Preferably, the emitted light forms any of one or four lobes.

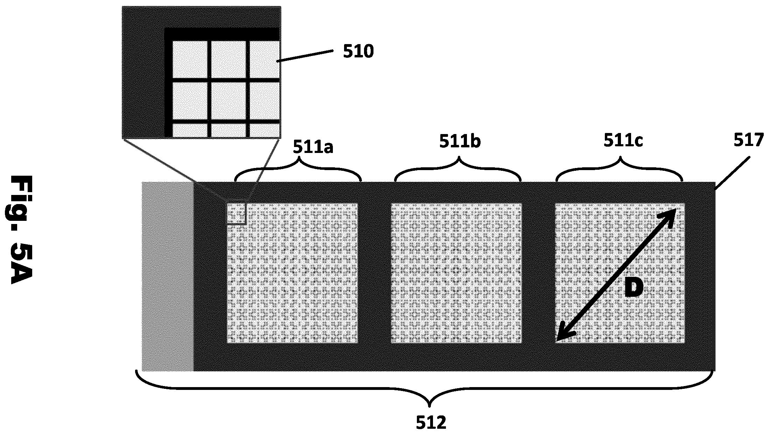

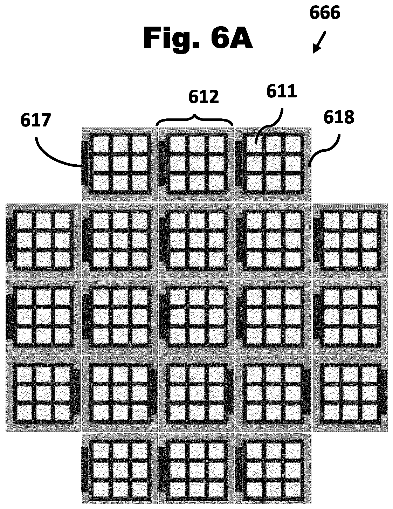

Examples of lasing clusters and lasing units that may be used in fiber laser pump modules according to the present disclosure, are further discussed hereinbelow in relation to **Figs. 5A-5B** and Figs. **6A-6B.**

The fiber laser pump module **100** may include a phase corrector **120**. The phase corrector **120** may be configured to receive emitted light from the one or more lasing clusters, i.e., from some or all of the lasing units. In some embodiments, the fiber laser pump module **100** may include more than one phase corrector.

The phase corrector **120** may include at least some phase correction elements. The phase correction elements may be configured for manipulating light waves emitted by one or more coherent lasing units. In some embodiments, each phase correction element may correspond to a coherent lasing unit. The phase correction elements may be configured to manipulate light emitted by said coherent lasing unit so as to produce interference and to output corrected beams **190.**

The corrected beams **190** may propagate substantially in a single direction. In some embodiments, the term "substantially" may imply divergence angles that are not significantly larger than the diffraction limit of a lasing unit. In some embodiments, the divergence of the corrected beams **190** may be up to 3 times a diffraction limit of the lasing unit. For reference, a diffraction limit is the minimum physically achievable divergence for a Gaussian beam. The diffraction limit may be given by a full-angle value of $4\lambda/\pi D$, where $\lambda$ is the emission wavelength and $D$ may be the beam diameter or its lateral extent.

The corrected beams may have a far field pattern predominantly formed by a single main lobe. In some embodiments, an optical power (i.e., power carried by the optical radiation) of the single main lobe may be at least 50% of an optical power of the far field pattern. Preferably, the optical power of the single main lobe may be at least 75% of the optical power of the far field pattern. More preferably, the optical power of the single main lobe may be at least 90% of the optical power of the far field pattern. Even more preferably, the optical power of the single main lobe may be at least 99% of the optical power of the far field pattern.

It is noted that having a single main lobe may enable high-efficiency coupling of the main (on-axis) lobe into an optical fiber. Coupling of the side lobes may be low or even absent. If the areal emitting fill factor of the lasing unit is sufficiently high, then the side lobes may contain very little power. This may obviate the need for any additional phase correction.

It is noted that in general, ray tracing within the near to far field transition region (e.g., Fresnel to Fraunhofer regions), may not follow geometrical optics. Therefore, the depicted ray paths upstream of corrected beams **190,** may not convey the complex coherent field propagation.

The fiber laser pump module **100** may include a focusing optics assembly **140** configured downstream of the phase corrector. The focusing optics assembly **140** may be configured for focusing the corrected beams onto a focused beam. The focused beam may be received by an input of an optical fiber **150**. An input end of the fiber **150** may be disposed in a focal place of the focusing optics assembly **140.** The optical fiber **150** may output the focused beam. The optical fiber may be mounted on a fiber block **153.**

Further optional features of the fiber laser pump module **100** are described herein below.

In some embodiments, the phase corrector **120** may be placed in the in the near-field region. The phase corrector **120** may provide appropriate phase delays across the aperture, in order to convert the source fixed-phase relationship into a constant (uniform) phase distribution. The uniform phase distribution, together with a near-uniform or Gaussian intensity profile, may be favorable for coupling to an optical fiber.

In some embodiments, the phase corrector **120** may be placed in the far-field region. The phase corrector **120** may operate as a diffractive optical element, e.g., as a Dammann grating. The phase corrector **120** may combine several mutually coherent far-field lobes in order to form the corrected beams **190.**

In some embodiments, the phase corrector **120** may be integrated into the lasing cluster **112** or into a lasing unit itself. In other words, the phase corrector **120** may be inseparable from the lasing cluster **112** or from a lasing unit without damaging them. For example, in the manufacture of the fiber laser pump module **100,** the stage of manufacturing the phase corrector **120** may include vapor-deposition techniques, where material may be deposited on the lasing cluster **112.** Alternatively, the phase corrector **120** may be manufactured by patterning and etching the material of the lasing cluster **112** or that of a constituent lasing unit. In another example, the phase corrector **120** may be attached to the lasing cluster **112,** e.g., by an adhesive outside the emission area.

The phase corrector **120** may be manufactured from a transparent material, e.g., glass or silica. The phase corrector **120** may be manufactured using lithographic or nano-imprint technology. In some embodiments, the phase corrector **120** may include any of the following features: phase levels, pillars, blocks, slits, nanopillars, nanoblocks, and/or nanoslits.

In some embodiments, the phase corrector **120** may include any of the following optical elements: a phase plate, a phase mask, a phase-shift mask, a phase-delay plate, a wavefront corrector, a metasurface, a Fourier hologram, a transmission grating, a phase grating, a Dammann grating, and/or a diffractive optical element.

In some embodiments, the phase corrector **120** may be configured to correct emission of a coherent source only. For example, all the phase correction elements may be configured to only correct emission of coherent sources.

The fiber laser pump module **100** may provide high optical power and high brightness. In some embodiments, an optical power provided by the fiber laser pump module **100** may be at least 30W. In other words, an optical power coupled to the optical fiber **150** may be at least 30 Watts. In some embodiments, each coherent lasing unit may be configured to emit a power of at least 100 mW (100 milliwatts). In some embodiments, the fiber laser pump module **100** may have an output brightness of at least 2 MW/(sq.cm×srad) (i.e., $2 \cdot 10^6 \frac{W}{cm^2 \times sr}$).

In some embodiments, the fiber laser pump module **100** may have an output brightness of at least 2 MW/sq.cm×srad, and an optical power provided by the fiber laser pump module **100** may be at least 30W. The optical fiber **150** may have a diameter of 105 micrometers and a numerical aperture (NA) of 0.22.

The plurality of semiconductor surface-emitting elements may be configured to emit light at specific wavelengths. In some embodiments, an emission wavelength of the plurality of semiconductor surface-emitting elements may be in the range of 770nm to 1070nm. Preferably, the emission wavelength of the plurality of semiconductor surface-emitting elements may be any of 915 nm and 976nm.

In some embodiments, the lasing units may be configured to provide a specific wavelength. In other words, the range of wavelengths (i.e., the linewidth) the lasing units may be configured to emit, may be narrower than a predefined threshold. In some embodiments, the linewidth of the lasing units may be less than 1nm. Preferably, the linewidth of the lasing units may be less than 0.5nm.

In some embodiments, the lasing units may include any of the semiconductor materials GaAs, AlAs, AlGaAs, InGaAs, InGaAsP, InP, and/or GaN.

In some embodiments, the lasing units may include tunnel junctions and/or buried tunnel junctions.

In some embodiments, the lasing units may be configured for emitting light from a semiconductor substrate side. Such a configuration may be referred to as "bottom emitting."

In some embodiments, the fiber laser pump module **100** may be configured to receive power from a power supply unit configured to supply power for edge-emitting laser modules. This can provide an advantage in simplifying the replacement of an edge-emitting laser pump module with the fiber laser pump module **100**. In some embodiments, a current supplied by the power supply unit may be in the range of 10A to 30A.

In some embodiments, the fiber laser pump module **100** may include a lens, disposed between a lasing unit and the phase corrector **120**. The lens may be configured for Fourier imaging of the emitted light from the lasing unit. In some embodiments, the lens may include a Fourier-lens. In some embodiments, the lens may be configured for Fourier imaging of the emitted light from several lasing units, or from a whole lasing cluster **112,** or from several lasing clusters. In some embodiments, the lens may include a micro-lens array, wherein some micro-lenses may correspond to some of the lasing units.

In some embodiments, the focusing optics assembly **140** may include two cylindrical lenses oriented along different axes. In some other embodiments, the focusing optics assembly **140** may consist of a single lens.

In some embodiments, fiber laser pump module **100** may include a plurality of lasing clusters. Each lasing cluster may be formed on a separate semiconductor die. In some embodiments, each lasing cluster may contain one or more lasing units.

In some embodiments, the lasing clusters may be electrically connected in series. In other words, a cathode of one lasing cluster may be electrically connected to an anode of another lasing cluster. Yet in other terms, an anode of one lasing cluster may be electrically connected to a cathode of another lasing cluster. In some embodiments, all lasing units in at least one lasing cluster may be electrically connected in parallel. In other words, the cathodes of all lasing units (in at least one lasing cluster) may be connected to each other, and their anodes may be connected to each other.

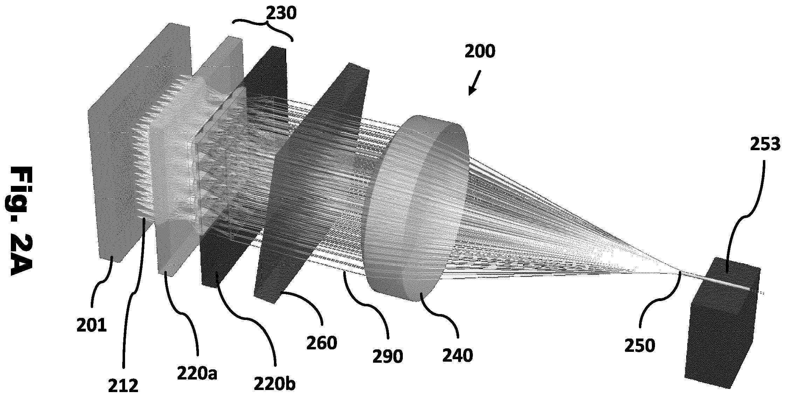

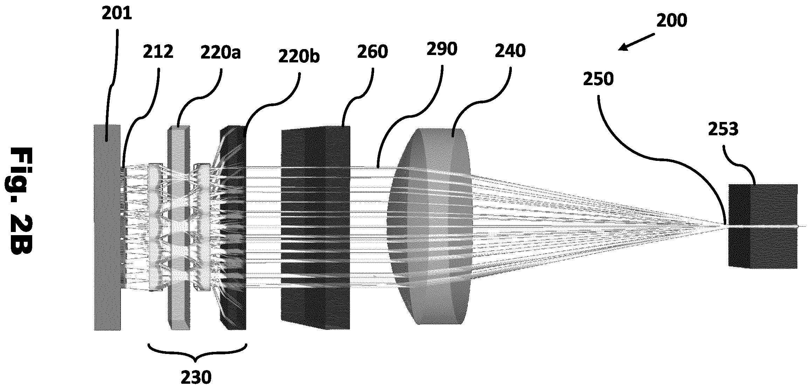

**Figs. 2A-2B** schematically illustrate a fiber laser pump module **200,** according to embodiments of the present disclosure. **Fig. 2A** illustrates the fiber laser pump module **200** in a perspective view, whereas **Fig. 2B** illustrates the fiber laser pump module **200** in a side view.

The fiber laser pump module **200** may include one or more lasing cluster **212**. The one or more lasing cluster **212** may include a plurality of lasing units disposed on a common emitting surface, for example, a baseplate **201**.

The plurality of lasing units may be optically decoupled, as explained hereinabove in relation to fiber laser pump module **100,** schematically illustrated in **Figs. 1A-1B.**

The plurality of lasing units may include at least some coherent lasing units. The coherent lasing units may include a plurality of semiconductor surface-emitting elements that may be optically coupled, as explained hereinabove in relation to fiber laser pump module **100.**

The fiber laser pump module **200** may include two phase correctors **220a 220b.** The two phase-correctors **220a 220b** may function as an amplitude-to-phase converter **230.** The amplitude to phase converter **230** may be configured to provide amplitude-to-phase conversion, for increasing an optical power propagating in a single direction. In some embodiments, the amplitude-to-phase converter **230** may include lenses. In some embodiments, the amplitude-to-phase converter **230** may be configured to increase an optical power density propagating in the single direction.

In some embodiments, the fiber laser pump module **200** may include an amplitude-to-phase converter that is distinct from the phase correctors. In other words, the amplitude-to-phase converter **230** may be configured to operate in combination with one or more phase corrector to provide corrected beams **290** that are substantially uniform in phase and have a substantially Gaussian intensity profile, as would be advantageous for fiber coupling.

The phase correctors **220a 220b** may have an input plane substantially parallel to the common emitting plane and configured to receive emitted light from one or more lasing clusters, i.e., from one or more lasing units.

The phase correctors **220a 220b** may include at least some phase correction elements. The phase correction elements may be configured for manipulating light emitted by the at least some coherent lasing units. Each phase correction element may correspond to one or more coherent lasing units. The phase correction elements may be configured to produce a specific interference pattern, so as to output at least some respective corrected beams **290.**

The corrected beams **290** may propagate substantially in a single direction, as explained hereinabove in reference to corrected beams **190** (i.e., in relation to fiber laser pump module **100).**

It is noted that in general, ray tracing within the near-to-far-field transition region (e.g., Fresnel to Fraunhofer regions), may not follow geometrical optics. Therefore, the depicted ray paths upstream of corrected beams **290,** may not convey the complex coherent field propagation.

The fiber laser pump module **200** may include a focusing optics assembly **240** configured downstream of the phase corrector. The focusing optics assembly **240** may be configured for focusing the at least some corrected beams onto an input of an optical fiber **250,** with the fiber input disposed in a focal place of the focusing optics assembly **240.** The optical fiber **250** may be mounted on a fiber block **253.**

In some embodiments, the focusing optics assembly **240** may include a rectangular lens, in order to match the shape of the lasing cluster **212** emission area. In some embodiments, the focusing optics assembly **240** may include with two cylindrical lenses, each oriented along a different axis. If corrected beams **290** may have different properties or dimensions in those axes, the two cylindrical lenses may provide a higher power coupling efficiency of corrected beams **290** into an optical fiber **250.**

The fiber laser pump module **200** may include a dichroic module **260** (i.e., a wavelength-selective reflector). The dichroic module **260** may be configured for blocking a backwards propagation of light waves at wavelengths that may be distinct from a wavelength emitted by the lasing units. The dichroic module **260** may provide a protection of the lasing cluster **212** from back-propagating power that may arrive from an external source (e.g., a fiber laser) through the optical fiber **250.** The dichroic module **260** may be positioned between the phase correctors **220a 220b** and the focusing optics assembly **240.**

The dichroic module **260** may be a clear optical blank, with a dielectric coating that is highly reflective at the wavelength of the fiber laser (e.g., 1064 nm), but highly transmissive at the lasing unit wavelength (e.g., 976 nm).

In some embodiments, the dichroic module **260** may be inclined with respect to the single direction of the corrected beams **290.** In other words, a normal vector to a surface of the dichroic module **260** may not be parallel to a Poynting vector of the corrected beams **290.** The dichroic module **260** may be inclined, in order to avoid on-axis back-reflection of incoming fiber laser power.

For the sake of brevity, details related to optional features of fiber laser pump module **200** corresponding to features also present in the embodiment of **Fig. 1** and which have been described hereinabove are not repeated.

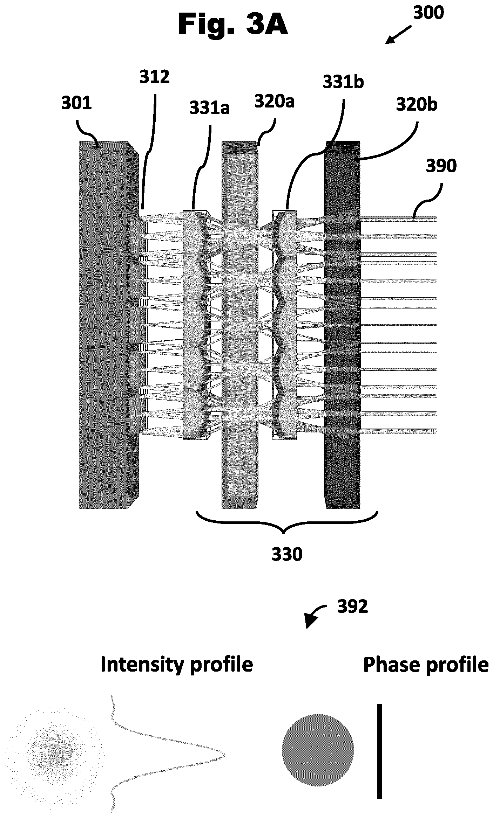

**Fig. 3A** schematically illustrates a fiber laser pump module **300,** according to embodiments of the present disclosure.

The fiber laser pump module **300** may include one or more lasing clusters **312.** The one or more lasing clusters **312** may include a plurality of lasing units disposed on a common emitting surface, for example, a baseplate **301.**

The plurality of lasing units may be optically decoupled, as explained hereinabove in relation to fiber laser pump module **100.**

The plurality of lasing units may include at least some coherent lasing units. The coherent lasing units may include a plurality of semiconductor surface-emitting elements that may be optically coupled, as explained hereinabove in relation to fiber laser pump module **100.**

The fiber laser pump module **300** may include a first phase corrector **320a** and a second phase corrector **320b.** The phase correctors **320a 320b** may have an input plane substantially parallel to the common emitting surface and configured to receive emitted light from the one or more lasing clusters, i.e., from one or more lasing units.

The phase correctors **320a 320b** may include at least some phase correction elements. The phase correction elements may be configured to produce a specific interference pattern, so as to output at least some respective corrected beams **390.**

The corrected beams **390** may propagate substantially in a single direction, as explained hereinabove in reference to corrected beams **190.** It is noted that, in general, ray tracing within the near-to-far-field transition region (e.g., Fresnel to Fraunhofer regions) may not follow geometrical optics. Therefore, the depicted ray paths upstream of corrected beams **390** may not convey the complex coherent field propagation.

The fiber laser pump module **300** may include an amplitude-to-phase corrector **330.** The amplitude-to-phase corrector **330** may include two phase-correctors **320a 320b,** may include a first lens **331a,** and may include a second lens **331b.** The first lens **331a** may be positioned upstream of the first phase corrector **320a.** The second lens **331b** may be positioned between the first phase corrector **320a** and the second phase corrector **320b.** The first lens **331a** and the second lens **331b** may include a plurality of micro-lens elements.

The amplitude-to-phase converter **330** may be configured to provide amplitude-to-phase conversion, for increasing an optical power propagating in a single direction. The amplitude-to-phase converter **330** may be further configured to increase an optical power density propagating in a single direction.

The amplitude-to-phase converter **330** may receive coherent radiation from one or more coherent lasing unit in the one or more lasing cluster **312.** The first lens **331a** may Fourier image the received coherent radiation onto the first phase corrector **320a.** The first phase corrector **320a** may apply a first phase transformation to the received coherent radiation, obtaining a phase-transformed coherent radiation. The second lens **331b** may Fourier image the phase-transformed coherent radiation onto the second phase corrector **320b.** The function of the second lens **331b** may be described as inverting the Fourier imaging that the first lens **331a** has performed, but with any amplitude and/or phase changes arising from the transformations applied the first phase corrector **320a.**

The second lens **331b** may output light having a residual phase non-uniformity. The residual phase non-uniformity may be corrected by the second phase corrector **320b.** The second phase corrector **320b** may apply a second phase transformation, thereby outputting the corrected beams **390.**

The corrected beams **390** may have a near-Gaussian intensity profile and may have a substantially uniform phase profile. High efficiency coupling into an optical fiber may be possible if the corrected beams **390** may only have minor intensity and phase deviations from the idealized profiles **392.** The divergence may be no more than 3 times the diffraction limit.

In some embodiments, more Fourier imaging stages and more phase correctors may be employed in order to improve the properties of the corrected beams **390.**

The lenses **331a 331b** may be selected to collect radiation over the lateral extent of the one or more lasing cluster **312.** In some embodiments, the lenses **331a 331b** may be manufactured as monolithic micro-lens arrays. The micro-lenses may correspond to the coherent lasing units in the one or more lasing cluster **312.** In some embodiments, a third phase corrector may be integrated with the lasing units in order to limit the divergence of the emitted radiation.

The fiber laser pump module **300** may include a focusing optics assembly (not shown) configured downstream of the phase corrector. The focusing optics assembly may be configured for focusing the corrected beams **390** onto an input of an optical fiber.

For the sake of brevity, details related to optional features of fiber laser pump module **300** corresponding to features also present in the embodiment of **Figs. 1-2** and which have been described hereinabove are not repeated.

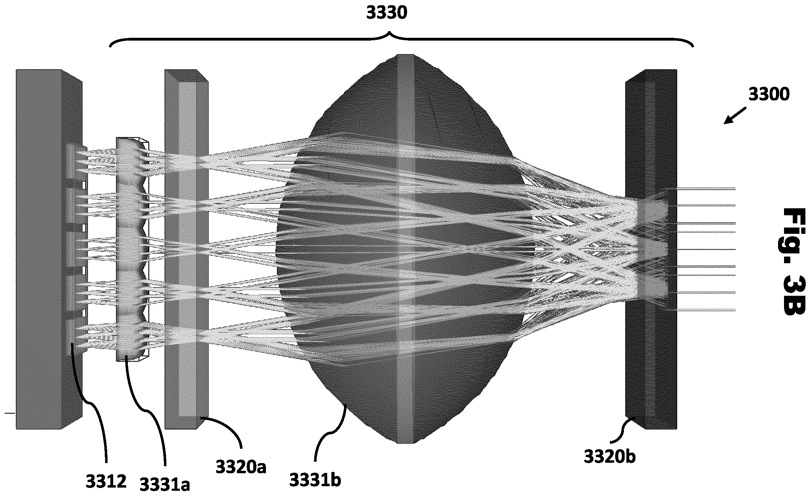

**Fig. 3B** schematically illustrate a fiber laser pump module **3300,** according to embodiments of the present disclosure. The fiber laser pump module **3300** may be a variant of the fiber laser pump module **300.**

The fiber laser pump module **3300** may include an amplitude-to-phase converter **3330.** The amplitude-to-phase corrector **3330** may include two phase-correctors **3320a 3320b,** may include a first lens **3331a,** and may include a second lens **3331b.** The first lens **3331a** may be positioned upstream of the first phase corrector **3320a.** The second lens **3331b** may be positioned between the first phase corrector **3320a** and the second phase corrector **3320b.** In some embodiments, the first lens **3331a** and/or the second lens **3331b** may include a plurality of micro-lens elements.

The second lens **3331b** may include a Fourier lens. The Fourier lens may be a single lens or an array of several lens elements. The second lens **3331b** may have fewer lens elements than the first lens **331b** of the fiber laser pump module **300.**

Having a large lens with a large focal length may benefit the fiber laser pump module **3300** by improving Fourier imaging, and by reducing aberrations. The benefits may require that that the coherent lasing units may be identical and may require substantially identical phase correction by the second phase corrector **3320b.**

In some embodiments, the first lens **3331a** may not be necessary if the first phase corrector **3320a** may be integrated with the lasing units within one or more lasing cluster **3312** (e.g., defined directly on the emitting surface). The amplitude-to-phase converter **3330** may include only one lens (the second lens **3331b),** followed by a single phase-corrector (the second phase-corrector **3320b).**

For the sake of brevity, at least some details related to optional features and to elements downstream of the phase corrector **3320b,** which are similar to the elements downstream of phase corrector **220b** described hereinabove with reference to Figures 1 and 2, are not repeated.

Different amplitude-to-phase converter embodiments given hereinabove may be selected in order to match the properties of specific lasing units, for example, an areal fill factor and lateral extent, so as to obtain corrected beams with minimal intensity and phase deviations from idealized profiles (e.g., the idealized profiles **392** illustrated in **Fig. 3A).**

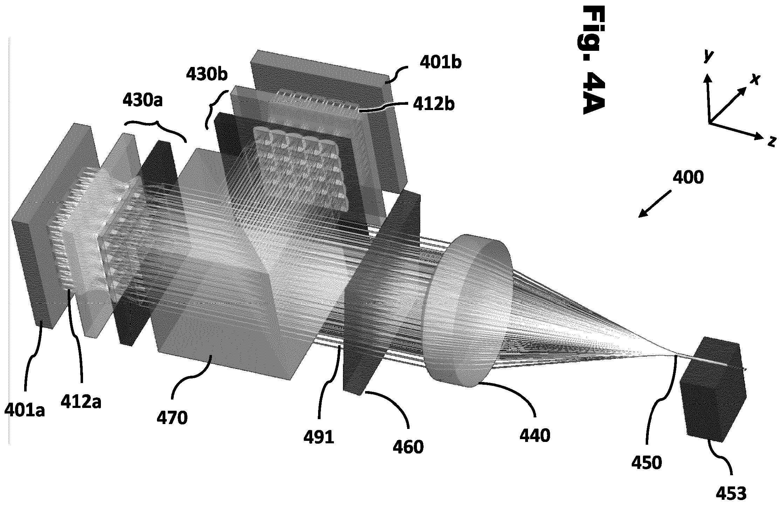

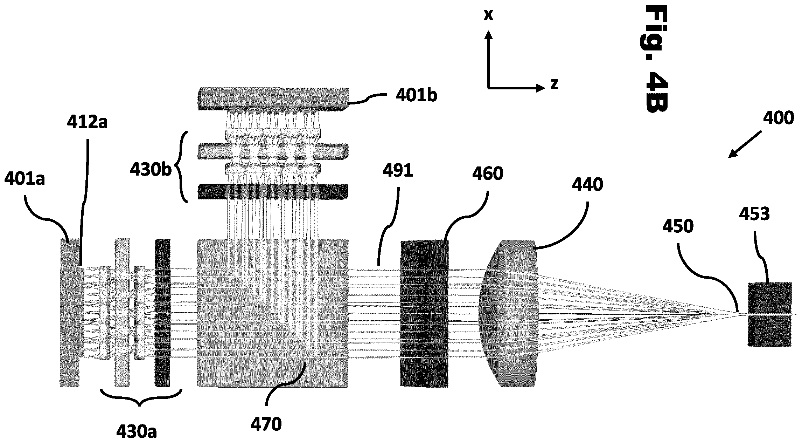

**Figs. 4A-4B** schematically illustrate a fiber laser pump module **400** including beam combining, according to embodiments of the present disclosure. **Fig. 4A** illustrates the fiber laser pump module **400** in a perspective view, whereas **Fig. 4B** illustrates the fiber laser pump module **400** in a top view.

The fiber laser pump module **400** may include one or more first lasing cluster **412a** and one or more second lasing cluster **412b.** The one or more first lasing cluster **412a** may be configured to emit light waves in a first polarization. The one or more second lasing cluster **412b** may be configured to emit light waves in a second polarization. In some embodiments, the first polarization may be orthogonal to the second polarization. For example, the first polarization may be linear polarization along the x-axis, and the second polarization may be linear polarization along the y-axis. It is noted that upstream a polarization-sensitive reflector **470** (further detailed hereinbelow), the z-axis may be defined as the direction of propagation of light (i.e., according to the Poynting-vector).

The one or more first lasing cluster **412a** and the one or more second lasing cluster **412b** may each include a plurality of lasing units. In each of the lasing clusters **412a 412b,** the plurality of lasing units may be disposed on a (corresponding) common surface, for example, baseplates **401a 401b.**

In each of the lasing clusters **412a 412b,** the plurality of lasing units may be optically decoupled, as described hereinabove in relation to fiber laser pump module **100.**

In each of the lasing clusters **412a 412b,** the plurality of lasing units may include at least some coherent lasing units. The coherent lasing units may include a plurality of semiconductor surface-emitting elements that may be optically coupled, as described hereinabove in relation to fiber laser pump module **100.**

The fiber laser pump module **400** may include a first one or more phase corrector and a second one or more phase corrector. The first one or more phase corrector may correspond to the one or more first lasing cluster **412a** and the second one or more phase corrector may correspond to the one or more second lasing cluster **412b.** The phase correctors may each have an input plane substantially parallel to the common emitting surface, and may be configured to receive emitted light from the lasing units.

The phase correctors may each comprise at least some phase correction elements. The phase correction elements may be configured for manipulating the optical phases of radiation emitted by one or more coherent lasing units. In some embodiments, each phase correction element may correspond to a coherent lasing unit. The phase correction elements may be configured to manipulate light emitted by said coherent lasing unit so as to produce a specific interference pattern, so as to output corrected beams.

The corrected beams may propagate substantially in a single direction. In some embodiments, the term "substantially" may imply divergence angles that are not significantly larger than the diffraction limit of a lasing unit.

The corrected beams may have a far-field pattern predominantly formed by a single main lobe. In some embodiments, an optical power (i.e., power carried by the optical radiation) of the single main lobe may be at least 50% of an optical power encompassed (i.e., carried) by the far-field pattern.

It is noted that, in general, ray tracing within the near-to-far-field transition region (e.g., Fresnel to Fraunhofer regions) may not follow geometrical optics. Therefore, the depicted ray paths upstream of corrected beams may not convey the complex coherent field propagation.

In some embodiments, the laser pump module **400** may include one or more amplitude-to-phase converters. The one or more amplitude-to-phase converters may correspond only to the one or more first lasing cluster **412a,** may correspond only to the one or more second lasing cluster **412b,** or may correspond to both first and second lasing clusters **412a 412b.** The one or more amplitude to phase converters may be as described hereinabove in relation to **Figs. 2A-3B.** For example, the laser pump module **400** may include a first amplitude-to-phase converter **430a** that may correspond the first lasing cluster **412a,** and may include a second amplitude-to-phase converter **430b** that may correspond the second lasing cluster **412b.** The first amplitude-to-phase converter **430a** may include the first one or more phase corrector, and the second amplitude-to-phase converter **430b** may include the second one or more phase corrector.

The fiber laser pump module **400** may include a polarization-sensitive reflector 470. The polarization-sensitive reflector **470** may be configured for combining light emitted by the one or more first lasing cluster **412a** and the one or more second lasing cluster **412b.** Thus, the polarization-sensitive reflector **470** may provide combined light **491.** For example, the polarization-sensitive reflector **470** may be a beam splitter. The beam splitter may be configured so as to have high reflectivity for the polarization along the y-axis, and high transmissivity for polarization along the x-axis. In some embodiments, the polarization-sensitive reflector **470** may be based on the principles of total internal reflection or Brewster angle.

In some embodiments, the polarization-sensitive reflector **470** may not include polarization rotators, for example, waveplates. Having no polarization rotators may have an advantage of reduced manufacturing cost.

The fiber laser pump module **400** may include a focusing optics assembly **440** configured downstream of the polarization-sensitive reflector **470.** The focusing optics assembly **440** may be configured for focusing the combined light **491** (having a plurality of corrected beams) onto an input of optical fiber **450.**

In some embodiments, the optical fiber **450** may be mounted on a fiber block **453.**

The combined light **491** may have mixed polarization. Optical fiber **450** may be multimode and not polarization-maintaining. Thus, the coupling efficiency of light (the combined light **491)** into the fiber may not be affected. Therefore, the brightness of light provided by a fiber laser pump module according to the present disclosure may be doubled by using polarization beam combination. Using polarization beam combination, the optical power provided may be doubled, but the area illuminated by the focusing optics assembly **440** may not change.

The polarization of the lasing clusters may be determined by introducing asymmetry in the lateral structure of the lasing units and/or of their surface-emitting elements, e.g., by imparting them with a rectangular or oblong shape. In some embodiments, the optical coupling in the coherent lasing units may be configured so as to selectively enhance one polarization over another polarization.

In some embodiments, the one or more lasing clusters **412a 412b** may be disposed on a single surface. The lasing one or more clusters **412a 412b** may emit light in the same direction. A reflective element (e.g., mirror or a prism) may redirect light provided by one of the lasing clusters by 90° to the polarization-sensitive reflector **470.**

In some embodiments, the one or more lasing clusters **412a 412b** may be identical. The different polarization of each lasing cluster may be determined according to an assembly procedure of the fiber laser pump module **400.** For example, the one or more second lasing cluster **412b** may be rotated relative to the one or more first lasing cluster **412a** so as to provide the second polarization.

It is notable that the one or more lasing clusters **412a 412b,** the phase correctors, and amplitude-to-phase converters **430a 430b** need not to be identical.

The fiber laser pump module **400** may include a dichroic module **460** (i.e., a wavelength-selective reflector). The dichroic module **460** may be configured for blocking a backward propagation of radiation at wavelengths that may be distinct from a wavelength emitted by the lasing units. The dichroic module **460** may provide a protection of the one or more lasing clusters **412a 412b** from back-propagating power that may arrive from an external source (e.g., a fiber laser) through the optical fiber **450.** The dichroic module may be disposed (positioned) downstream of the polarization-sensitive reflector **470.**

For the sake of brevity, details related to optional features of fiber laser pump module **400** corresponding to features also present in the embodiments of **Figs. 1-3** and which have been described hereinabove are not repeated.

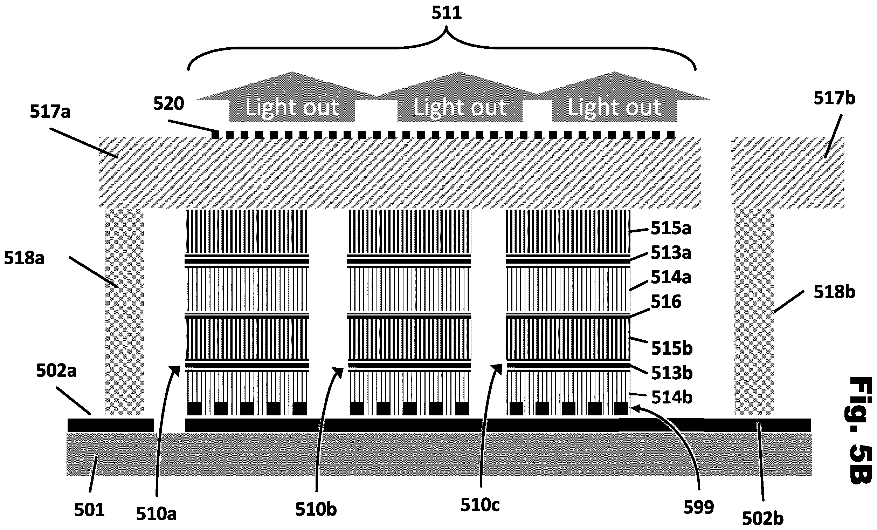

**Figs. 5A-5B** schematically illustrate a lasing cluster **512** according to embodiments of the present disclosure. **Fig. 5A** illustrate a top view of the lasing cluster **512** in a perspective view, whereas **Fig. 5B** illustrate a cross-section of the lasing cluster **512.**

The lasing cluster **512** may have a plurality of coherent lasing units **511a 511b 511c.** Each coherent lasing unit may have a plurality of surface-emitting elements, such as surface-emitting element **510.** In some embodiments, the surface-emitting elements may be VCSEL emitting elements. The surface-emitting elements may be arrayed with a small spacing. The lateral extent of a coherent lasing unit may be denoted by $D$. The lateral extent $D$ may characterize a size of emission of the coherent lasing unit, for example, the lateral extent $D$ may be a characteristic diameter of one or more light beams emitted by the coherent lasing unit. In a different example, the lateral extent $D$, when squared, may provide a characteristic emission area.

In some embodiments, the spacing between any two adjacent surface-emitting elements may be in the range of 0.5 to 5 microns. In some embodiments, a length-scale of an surface-emitting element may be in the range of 2 to 9 microns. In some embodiments, the surface-emitting elements **510** may form a hexagonal, square or a rectangular array.

The plurality of coherent lasing units **511a 511b 511c** may be built on a single semiconductor die. The plurality of coherent lasing units **511a 511b 511c** may be optically separated from one another (e.g., by etching and/or by a sufficient separation distance) in order to avoid any optical cross-talk.

The separation of the coherent lasing units **511a 511b 511c** from each other may lead to non-emitting area therebetween. Electrical contacts may be positioned in the non-emitting area (e.g., electrical traces).

In some embodiments, the plurality of coherent lasing units **511a 511b 511c** may include VCSEL and/or VCSEL arrays designed according to a reflectivity modulated layer **599** (represented by chains of squares), in a similar fashion as in US patent No. 5086430, columns 3-4. The die **512** may include semiconductor substrate **517a** (e.g., GaAs) and may include repetitions of epitaxial layers (made of, e.g., GaAs, AlGaAs, AlAs and other compound semiconductors) grown on it. The epitaxial layers may include P-doped layers **514a 514b** and N-doped layers **515a 515b.**

The P-doped layers **514a 514b** and N-doped layers **515a 515b** may form P-N junctions. In forward-biased P-N junctions, active regions **513a 513b** may be formed.

The active regions **513a 513b** may include quantum wells (e.g., layers of undoped InGaAs) that may be separated by barrier layers (made of e.g., GaAsP). The quantum wells may provide photon generation by recombination of charge carriers.

Multiple active regions **513a 513b** may be stacked using one or more tunnel diode junction regions **516,** so as to provide charge carrier type conversion (e.g.

from electrons to holes) between the active regions **513a 513b.**

The P-doped layers **514a 514b** and N-doped layers **515a 515b** may include mirror regions. The mirror regions may be made from, e.g., alternating AlAs/GaAs layers. The mirror regions may be configured to partially reflect light. Thus, the mirror regions may form a laser resonator. The P-doped layers **514a 514b** and N-doped layers **515a 515b** may include spacer regions. The spacer regions may provide a distance between the mirror regions, thereby determining a resonant wavelength of the coherent lasing units **511a 511b 511c.**

The reflectivity modulated layer **599** may be made from a layer periodically alternating between materials having different reflectivity properties. For example, Ti and Au, or Ti and an Au-capped dielectric layer. The reflectivity modulated layer **599** may partially serve as a contact layer to the P-doped layer **514b,** e.g., by providing electrical injection through the Ti-covered sections of the reflectivity modulated layer **599.** The reflectivity modulated layer **599** may provide a specific mutual optical coupling pattern, e.g. an array supermode, among the plurality of the surface- emitting elements within each of the coherent lasing units **511a, 511b, 511c.** Therefore, the surface-emitting elements of each coherent lasing unit may be mutually proximity-coupled and substantially mutually coherent. Additionally, the surface-emitting elements of a given lasing unit do not interfere with the surface-emitting elements of another neighboring lasing unit (i.e. the lasing units **511a 511b 511c** are incoherent with one another).

The semiconductor die may be mounted epitaxial-side down onto metallized contact pads **502a 502b** atop a baseplate **501.** Contact pad **502a** may be electrically connected to the semiconductor substrate **517a** via an electrode **518a.**

The plurality of coherent lasing units **511a 511b 511c** may be electrically connected in parallel. For example, cathodes of the coherent lasing units may be electrically connected via the contact pad **502b,** and anodes of the coherent lasing units may be electrically connected via the semiconductor substrate **517a.**

The baseplate **501** may serve as a die carrier. The baseplate **501** may be manufactured from an electrically insulating material with a high thermal conductivity. As indicated hereinabove, a phase corrector **520** may be integrated with the coherent lasing units **511a 511b 511c** and/or with the whole lasing cluster **512.** The phase corrector **520** may be integrated with the semiconductor substrate **517a** e.g., by etching, or deposited onto it.

The lasing cluster **512** built on a single semiconductor die may provide several watts of optical power. To scale the power further, more dice may be energized together, preferably as a series circuit. To this end, contact pad **502b** may further connect to cathode electrode **518b** of another lasing cluster built on another die having a semiconductor substrate 517b. More and more lasing clusters/dice may be energized with the same current, with extra drive voltage added for each die.

In some embodiments, semiconductor substrate **517a 517b** may be formed from insulating or semi-insulating material, and some or all the lasing units **511a 511b 511c** may be connected in series. In some embodiments, the semiconductor die may only contain a single coherent lasing unit (one of **511a 511b 511c**) and the lasing cluster **512** may contain multiple semiconductor dice.

It is notable that the type and parameters of the coherent lasing units and surface-emitting elements used in this embodiment are not limiting. Different embodiments may use different types of SEL, as known in the art.

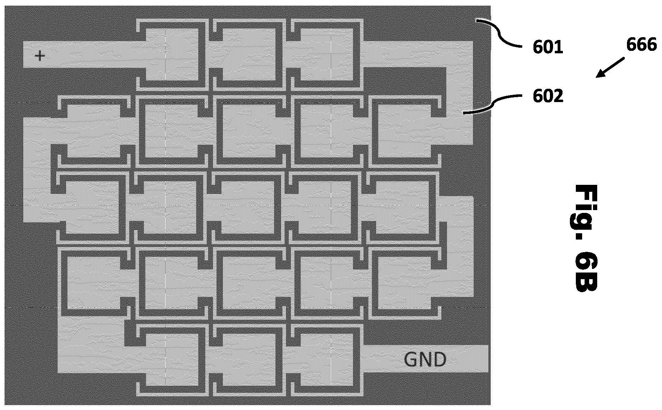

**Figs. 6A** schematically illustrates a lasing system **666** comprising a plurality of lasing clusters built on a corresponding plurality of dice **612** according to embodiments of the present disclosure. Fig. **6B** illustrates an electrical connection arrangement for the lasing system of **Fig. 6A.**

Each lasing cluster built on a die **612** may contain a plurality of coherent lasing units **611** (e.g., nine). The coherent lasing units **611** may be incoherent with one another. Coherent lasing units in different dice may also be mutually incoherent, e.g., optically decoupled.

The plurality of lasing clusters may be electrically connected in series. A cathode electrode **618** may run along the perimeter of each die, except for an open section (where substrate **617** may be accessible for establishing an electrical connection). In the manufacturing process, if the dice are flip-chip bonded onto matching contact pads **602** on baseplate **601** (illustrated in **Fig. 6B),** the open section may allow adjacent dice to be connected without shorting in the region where a contact pad may extend to an adjacent electrode (e.g., as illustrated in **Fig. 5B).** The plurality of dice may be energized in a series circuit by applying electrical drive power to the terminals, labeled as "GND" and "+".

The lasing clusters of the system may be configured so that a current supplied to each lasing cluster is in the range of 10A to 30A. For example, a number of coherent lasing units per lasing cluster on a die may be selected to meet said current supply requirement.

The combination of parallel electrical connections (of the coherent lasing units) and series electrical connections (of dice/clusters) may provide flexibility in the engineering of lasing system **666** according to the present disclosure. Examples include meeting specific heat density, heat distribution, voltage, current, current-density, and/or other electrical pumping requirements.

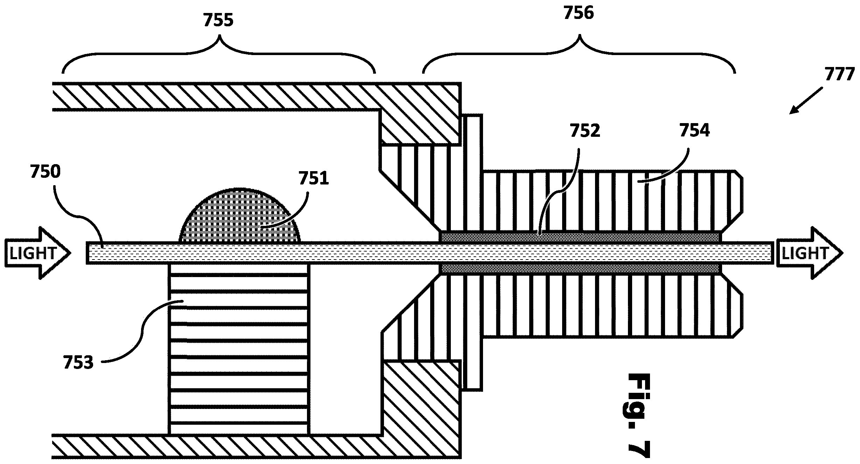

**Fig. 7** schematically illustrate an optical fiber coupling assembly **777,** according to embodiments of the present disclosure. The present disclosure allows for an efficient coupling of light arriving from the focusing optics assembly (e.g., **140** in **Figs. 1A-B)** into an optical fiber while providing a safe disposal of stray light due to phase correction or focusing errors.

The optical fiber coupling assembly **777** may have a proximal section **755** and a distal section **756**. In the proximal section **755,** an optical fiber **750** may be surrounded by a first encapsulation medium **751** (e.g., an adhesive) and may be supported by a block **753**. In the distal section **756,** the optical fiber 750 **may** be surrounded by a second encapsulation medium **752** (e.g., a sealing adhesive) and may pass inside a ferrule **754**. The first encapsulation medium **751** may have a refractive index close to, but higher than, that of the optical fiber. The second encapsulation medium **752** may have a refractive index between that of the optical fiber **750** and that of the first encapsulation medium **751**. In some embodiments, the refractive index of the first encapsulation medium **751** and second encapsulation medium **752** may be in the range of 1.45 to 1.6.

The optical fiber's tip may extend into free space. This is in order to allow any incoming stray rays, that propagate completely outside the fiber, to diverge. Thus, the parasitic power carried by the stray rays may be dissipated over a large area. The optical fiber **750** may be surrounded by the first encapsulation medium **751**.

As indicated hereinabove, the first encapsulation medium **751** may have a refractive index close to, but higher than, that of the optical fiber **750**. This may allow the first encapsulation medium **751** to extract parasitic light from the fiber cladding.

The first encapsulation medium **751** and the second encapsulation medium **752** may firmly lock the position of the optical fiber **750** and may ensure its stability. The encapsulation media **751 752** may have a low outgassing properties, in order to ensure an absence of contamination on the delicate optics inside the laser pump module throughout its operating life.

Fiber block **753** may be built from a material selected to have high thermal conductivity, allowing the waste heat generated by the absorption of the extracted parasitic optical power to be dissipated through the block floor. The fiber block **753** may thus act as a heat-sink. The fiber block **753** may also have a refractive index that is higher than that of the first encapsulation medium **751,** allowing the parasitic optical power to be extracted into the fiber block **753**. Thus, the fiber block **753** may act as a light-sink. Therefore, the fiber block **753** may perform a dual function, of sinking both light and heat, by converting the extracted light into heat and safely dissipating the heat.

The first section **755** of may remove parasitic light and may be capable of dissipating several watts of waste optical power without a significant absorption-induced temperature increase. However, there still might remain residual parasitic power. The residual parasitic power may travel either as high-angle ray components within the optical fiber **750,** or as free-space rays of the extracted power exiting the first encapsulation medium **751**. The residual parasitic power may be removed by the second section **756**.

The second section **756** may include a ferrule **754** that may house the optical fiber **750** and may be made from a material that has high mechanical strength, thus supporting the fixation of the optical fiber **750**. The front part of the ferrule **754** may serve as a tight aperture that may block the free-space rays extracted by the first section **755**.

The inner duct of the ferrule **754** may be filled with the second encapsulation medium **752** (e.g., a sealing adhesive), that may have a refractive index between that of the optical fiber and the refractive index of the first encapsulation medium **751**. By having the refractive index closer to that of the optical fiber than encapsulation medium **751,** encapsulation medium **752** may extract residual low-angle parasitic light from the fiber cladding.

The extraction of residual low-angle parasitic light may be further facilitated by the second section **756** being longer than the first section **755,** that may allow an extended "mode-stripping" length. Therefore, the total mode-stripping length afforded by the cascaded combination of the first section **755** and the second section **756** may be sufficient for the removal of most, if not all, of the parasitic light from the fiber cladding. This may provide for a safe delivery of high-power optical output of the fiber pump module through an extended external portion of an uncooled optical fiber.

The second encapsulation medium **752** may provide an impenetrable environmental barrier preventing the ingress of humidity inside the fiber pump module through the ferrule **754**.

Fiber laser pump modules as disclosed herein may be incorporated in applications requiring high-power laser light sources. For example, a fiber laser system may include fiber optic pump modules described hereinabove.

Having described and illustrated the principles of the disclosed technology with reference to the illustrated embodiments, it will be recognized that the illustrated embodiments can be modified in arrangement and detail without departing from such principles. The technologies from any example can be combined with the technologies described in any one or more of the other examples.

Therefore, casting into a language of clauses, the present disclosure provides methods, systems and circuits according to, but not limited to, the following clauses:

**Clause 1:** A fiber laser pump module comprising:

(a) one or more lasing clusters comprising a plurality of lasing units disposed in a common plane;

i) wherein said plurality of lasing units are optically decoupled, such that light waves emitted by one lasing unit does not interfere with light waves of another lasing unit;

ii) wherein the plurality of lasing units comprises at least some coherent lasing units, each coherent lasing unit including a plurality of semiconductor surface-emitting laser elements that are mutually optically coupled, so that light waves emitted by one surface-emitting element interfere with light waves emitted by another surface-emitting element;

(b) one or more phase correctors configured to receive emitted light from the one or more lasing clusters; wherein said one or more phase correctors comprise at least some optical phase correction elements configured for manipulating light emitted by said at least some coherent lasing units so as to produce interference to output corrected beams propagating substantially in a single direction and having a far field pattern predominantly formed by a single main lobe;

(c) a focusing optics assembly configured downstream of said one or more phase correctors for focusing said corrected beams into a focused beam; and

(d) an optical fiber for receiving and outputting the focused beam, wherein an input end of said optical fiber is disposed in the focal plane of said focusing optics assembly.

**Clause 2:** As recited in clause 1, wherein said plurality of lasing units are disposed by a first proximity being at least a predefined threshold so as to prevent mutual optical proximity coupling; and wherein said plurality of surface-emitting elements in each coherent lasing unit are disposed by a second proximity being shorter than said predefined threshold so as to induce mutual optical proximity coupling.

**Clause 3:** As recited in clause 2, wherein said predefined threshold is less than 10 times the wavelength emitted by said surface-emitting elements, wherein said wavelength defined according to light propagation in free space.

**Clause 4:** As recited in any one of clauses 2 to 3, wherein said predefined threshold is 10 micrometers.

**Clause 5:** As recited in any former clause, wherein said single main lobe carries at least 50% of an optical power carried by said far field pattern, preferably at least 75%, more preferably at least 90%, even more preferably at least 99%.

**Clause 6:** As recited in any former clause, wherein a divergence of said corrected beams is up to 3 times a diffraction limit of a lasing unit.

**Clause 7:** As recited in any former clause, wherein each lasing unit is configured to emit a power of at least 100 mW with a spectral linewidth of less than 1 nm, preferably less than 0.5 nm.

**Clause 8:** As recited in any former clause, comprising a plurality of lasing clusters, each lasing cluster being formed from a separate semiconductor die and containing one or more lasing units.

**Clause 9:** As recited in clause 8, wherein said lasing clusters are electrically connected in series, wherein a cathode of a lasing cluster is electrically connected to an anode of a following lasing cluster.

**Clause 10:** As recited in any former clause, wherein all lasing units in at least one lasing cluster are electrically connected in parallel.

**Clause 11:** As recited in any former clause, wherein said surface-emitting elements comprise any of: a photonic crystal, a photonic lattice, an optical grating, a distributed Bragg reflector (DBR), a distributed feedback (DFB) region, an etched region, a metal region, a dielectric region, a regrown semiconductor region, a reflectivity-modulated region.

**Clause 12:** As recited in any former clause, wherein said surface-emitting elements included in at least one of said at least some coherent lasing units are arrayed on a period of less than 10 micrometers.

**Clause 13:** As recited in any former clause, wherein said one or more phase correctors are configured to provide amplitude-to-phase conversion for increasing an optical power propagating in said single direction.

**Clause 14:** As recited in any former clause, wherein said one or more phase correctors comprise any of phase plate, phase mask, phase-shift mask, phase-delay plate, wavefront corrector, metasurface, Fourier hologram, transmission grating, phase grating, Dammann grating, and diffractive optical element.

**Clause 15:** As recited in any former clause, wherein said one or more phase correctors comprise any of phase levels, pillars, blocks, slits, nanopillars, nanoblocks, and nanoslits.

**Clause 16:** As recited in any former clause, having an output brightness of at least 2 MW/(sq.cm×srad).

**Clause 17:** As recited in any former clause, wherein an emission wavelength of said plurality of surface-emitting elements is in the range of 770 nm to 1070 nm, preferably any of 915 nm and 976 nm.

**Clause 18:** As recited in any former clause, comprising:

(a) one or more first lasing cluster configured to emit light waves in a first polarization;
(b) one or more second lasing cluster configured to emit light waves in a second polarization; and
(c) a polarization-sensitive reflector configured for combining emitted light by said one or more first lasing cluster and said one or more second lasing cluster.

**Clause 19:** As recited in any former clause, comprising a dichroic module configured for blocking a backwards propagation of wavelengths distinct from a wavelength emitted by said one or more lasing cluster, wherein said dichroic module is positioned between the one or more phase correctors and the focusing optics assembly.

**Clause 20:** As recited in clause 19, wherein said dichroic module is inclined with respect to said single direction of said corrected beams.

**Clause 21:** As recited in any former clause, comprising a micro-lens array disposed between at said lasing units and said one or more phase correctors, said micro-lens array configured for Fourier imaging of light waves emitted by at least some of said lasing units, wherein at least some micro-lenses correspond to at least some of said lasing units.

**Clause 22:** As recited in any former clause, wherein said phase corrector is integrated into the lasing cluster.

**Clause 23:** As recited in any former clause, wherein said focusing optics assembly comprises two cylindrical lenses oriented along different axes.

**Clause 24:** As recited in any former clause, wherein said focusing optics assembly comprises a single lens.

**Clause 25:** As recited in any former clause, wherein light emitted from the coherent lasing units forms a plurality of far-field lobes, preferably four lobes.

**Clause 26:** As recited in any former clause, wherein said lasing units comprise any of the semiconductor materials GaAs, AlAs, AlGaAs, InGaAs, InGaAsP, InP, and GaN.

**Clause 27:** As recited in any former clause, wherein said lasing units comprise tunnel junctions or buried tunnel junctions.

**Clause 28:** As recited in any former clause, wherein said emitted light is emitted from a substrate side of said lasing units.

**Clause 29:** The fiber laser pump module according to any one of the preceding claims, configured to receive power from a power supply unit configured to supply power for edge-emitting laser modules.

**Clause 30:** As recited in any former clause, wherein a current supplied by a power supply unit is in the range of 10A to 30A.

**Clause 31:** As recited in any former clause, wherein a first section of said optical fiber is surrounded by a first encapsulation medium, and a second section of the fiber is surrounded by a second encapsulation medium inside a ferrule, wherein said first and second encapsulation media having a refractive index close to, but higher than that of the fiber.

**Clause 32:** As recited in clause 31, wherein said refractive index is in the range of 1.45 to 1.6.

**Clause 33:** A fiber laser system comprising the fiber laser pump module as recited in any former clause.

**Clause 34:** A solid-state optical gain medium comprising any of erbium and ytterbium and energized by optical power from the fiber optic pump module as recited in any former clause.

## Claims

1. A fiber laser pump module comprising:

   **(a)** one or more lasing clusters comprising a plurality of lasing units disposed in a common plane;

   > **i)** wherein said plurality of lasing units are optically decoupled, such that light waves emitted by one lasing unit does not interfere with light waves of another lasing unit;
   > **ii)** wherein the plurality of lasing units comprises at least some coherent lasing units, each coherent lasing unit including a plurality of semiconductor surface-emitting laser elements that are mutually optically coupled, so that light waves emitted by one surface-emitting element interfere with light waves emitted by another surface-emitting element;

   **(b)** one or more phase correctors configured to receive emitted light from the one or more lasing clusters; wherein said one or more phase correctors comprise at least some optical phase correction elements configured for manipulating light emitted by said at least some coherent lasing units so as to produce interference to output corrected beams propagating substantially in a single direction and having a far field pattern predominantly formed by a single main lobe;
   **(c)** a focusing optics assembly configured downstream of said one or more phase correctors for focusing said corrected beams into a focused beam; and
   **(d)** an optical fiber for receiving and outputting the focused beam, wherein an input end of said optical fiber is disposed in the focal plane of said focusing optics assembly.

2. The fiber laser pump module according to claim 1, wherein said plurality of lasing units are disposed by a first proximity being at least a predefined threshold so as to prevent mutual optical proximity coupling; and wherein said plurality of surface-emitting elements in each coherent lasing unit are disposed by a second proximity being shorter than said predefined threshold so as to induce mutual optical proximity coupling.

3. The fiber laser pump module according to claim 2, wherein said predefined threshold is less than 10 times the wavelength emitted by said surface-emitting elements, wherein said wavelength defined according to light propagation in free space.

4. The fiber laser pump module according to any one of claims 2 to 3, wherein said predefined threshold is 10 micrometers.

5. The fiber laser pump module according to claim 1, wherein said single main lobe carries at least 50% of an optical power carried by said far field pattern, preferably at least 75%, more preferably at least 90%, even more preferably at least 99%.

6. The fiber laser pump module according to any one of the preceding claims, wherein a divergence of said corrected beams is up to 3 times a diffraction limit of a lasing unit.

7. The fiber laser pump module according to any one of the preceding claims, wherein each lasing unit is configured to emit a power of at least 100 mW with a spectral linewidth of less than 1 nm, preferably less than 0.5 nm.

8. The fiber laser pump module according to any one of the preceding claims, comprising a plurality of lasing clusters, each lasing cluster being formed from a separate semiconductor die and containing one or more lasing units.

9. The fiber laser pump module according to claim 8, wherein said lasing clusters are electrically connected in series, wherein a cathode of a lasing cluster is electrically connected to an anode of a following lasing cluster.

10. The fiber laser pump module according to any one of the preceding claims, wherein all lasing units in at least one lasing cluster are electrically connected in parallel.

11. The fiber laser pump module according to any one of the preceding claims, wherein said surface-emitting elements included in at least one of said at least some coherent lasing units are arrayed on a period of less than 10 micrometers.

12. The fiber laser pump module according to any one of the preceding claims, comprising a micro-lens array disposed between at said lasing units and said one or more phase correctors, said micro-lens array configured for Fourier imaging of light waves emitted by at least some of said lasing units, wherein at least some micro-lenses correspond to at least some of said lasing units, wherein said phase corrector is integrated into the lasing cluster.

13. The fiber laser pump module according to any one of the preceding claims, wherein light emitted from the coherent lasing units forms a plurality of far-field lobes, preferably four lobes.

14. The fiber laser pump module according to any one of the preceding claims, configured to receive power from a power supply unit configured to supply power for edge-emitting laser modules, preferably wherein a current supplied by a power supply unit is in the range of 10A to 30A.

15. The fiber laser pump module according to any one of the preceding claims, wherein a first section of said optical fiber is surrounded by a first encapsulation medium, and a second section of the fiber is surrounded by a second encapsulation medium inside a ferrule, wherein said first and second encapsulation media having a refractive index close to, but higher than that of the fiber, wherein said refractive index is preferably in the range of 1.45 to 1.6.

Fig. 1A

Fig. 1B

**Fig. 2A**

**Fig. 2B**

# Fig. 3A

Intensity profile

Phase profile

## Fig. 3B

3300

3330

3320b

3331b

3320a

3331a

3312 3331a

# Fig. 4A

Fig. 4B

Fig. 5A

Fig. 5B

# Fig. 6A

666

617 612 611 618

**Fig. 6B**

Fig. 7

Europäisches
Patentamt

European
Patent Office

Office européen
des brevets

## EUROPEAN SEARCH REPORT

**Application Number**

EP 25 15 5704

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 8 248 700 B1 (ZORABEDIAN PAUL [US]) 21 August 2012 (2012-08-21) | 1,2, 5-10,12, 14,15 | INV. H01S3/094 H01S5/042 |
| Y | * column 3, line 27 - column 8, line 60; figures 1-3,8 * <br> * column 9, line 41 - column 10, line 18 * <br> ----- | 3,4,11, 13 | H01S5/183 H01S5/42 <br><br> ADD. |
| X | US 10 630 053 B2 (OPTIPULSE INC [US]) 21 April 2020 (2020-04-21) | 1,2, 5-10,12, 14,15 | H01S3/0941 H01S5/065 H01S5/40 |
| Y | * column 1, line 31 - column 2, line 23; figures 1-7,16,25-29 * <br> * column 3, line 21 - column 6, line 21 * <br> * column 21, line 44 - column 22, line 11; claims 1,12,17 * <br> ----- | 3,4,11, 13 | H01S5/00 |
| Y | LUNDEBERG L ET AL: "Spatial coherence measurements in arrays of coupled vertical cavity surface emitting lasers", APPLIED PHYSICS LETTERS, AMERICAN INSTITUTE OF PHYSICS, 2 HUNTINGTON QUADRANGLE, MELVILLE, NY 11747, vol. 90, no. 2, 8 January 2007 (2007-01-08), pages 21103-021103, XP012094703, ISSN: 0003-6951, DOI: 10.1063/1.2431474 * pages 021103-1, right-hand column, paragraph 2 - pages 021103-3, right-hand column, paragraph 3; figures 1-3 * <br> ----- | 3,4,11, 13 | |

TECHNICAL FIELDS SEARCHED (IPC)

H01S

-/--

The present search report has been drawn up for all claims

| Place of search | Date of completion of the search | Examiner |
|---|---|---|
| Munich | 24 June 2025 | Laenen, Robert |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

**EUROPEAN SEARCH REPORT**

Application Number

EP 25 15 5704

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | HERGENHAN GUIDO ET AL: "Coherent coupling of vertical-cavity surface-emitting laser arrays and efficient beam combining by diffractive optical elements: concept and experimental verification", APPLIED OPTICS, vol. 42, no. 9, 20 March 2003 (2003-03-20) , pages 1667-1680, XP055778519, US ISSN: 0003-6935, DOI: 10.1364/AO.42.001667 * the whole document * | 1,5,6 | |

-----

TECHNICAL FIELDS
SEARCHED      (IPC)

The present search report has been drawn up for all claims

| Place of search | Date of completion of the search | Examiner |
|---|---|---|
| Munich | 24 June 2025 | Laenen, Robert |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 15 5704

This annex lists the patent family members relating to the patent documents cited in the above-mentioned European search report.
The members are as contained in the European Patent Office EDP file on
The European Patent Office is in no way liable for these particulars which are merely given for the purpose of information.

24-06-2025

| Patent document cited in search report | | Publication date | Patent family member(s) | Publication date |
|---|---|---|---|---|
| US 8248700 | B1 | 21-08-2012 | NONE | |
| US 10630053 | B2 | 21-04-2020 | NONE | |

EPO FORM P0459

For more details about this annex : see Official Journal of the European Patent Office, No. 12/82

**REFERENCES CITED IN THE DESCRIPTION**

**Patent documents cited in the description**

- US 7773655 B
- US 8000360 B
- US 7733932 B
- US 7764723 B
- US 6898222 B
- US 8437086 B
- US 8427749 B
- US 8711894 B
- US 6124973 A
- US 7751458 B
- US 8576885 B
- US 8929407 B

- WO 2023110203 A
- US 7009216 B
- WO 2021220276 A
- US 7535943 B
- US 6507595 B
- US 5086430 A
- US 6608849 B
- US 5903590 A
- JP 2022043541 B
- EP 3425755 A
- JP 2022043541 A